# EUROPÄISCHE PATENTSCHRIFT

(11) **EP 2 689 644 B1**
(45) Veröffentlichungstag und Bekanntmachung des Hinweises auf die Patenterteilung: **31.07.2019**
(21) Anmeldenummer: 12717621.2
(22) Anmeldetag: 23.03.2012
(51) Int. Cl.: H05K 3/40, H05K 1/11, H05K 3/20, H01R 43/20, H05K 13/04

(54) **VERFAHREN UND BESTÜCKUNGSVORRICHTUNG ZUR HERSTELLUNG EINES ELEKTRISCHEN KONTAKTAUFNEHMERPLÄTTCHENS UND ZUR AUTOMATISIERTEN BESTÜCKUNG EINES ELEKTRISCHEN ODER ELEKTRONISCHEN MODULS MIT DEM KONTAKTAUFNEHMERPLÄTTCHEN**
METHOD AND POPULATING DEVICE FOR PRODUCING AN ELECTRIC CONTACT SENSOR PLATE AND FOR POPULATING AN ELECTRIC OR ELECTRONIC MODULE WITH THE CONTACT SENSOR PLATE IN AN AUTOMATED MANNER
PROCÉDÉ ET DISPOSITIF D'IMPLANTATION POUR FABRIQUER UNE PLAQUETTE RÉCEPTRICE DE CONTACT ÉLECTRIQUE ET POUR ÉQUIPER AUTOMATIQUEMENT UN MODULE ÉLECTRIQUE OU ÉLECTRONIQUE AVEC LA PLAQUETTE RÉCEPTRICE DE CONTACT

(30) Priorität: 24.03.2011 DE 102011006070
(43) Veröffentlichungstag der Anmeldung: 29.01.2014
(73) Patentinhaber: Continental Teves AG & Co. OHG, 60488 Frankfurt am Main (DE)
(72) Erfinder: HEISE, Andreas, 64390 Erzhausen (DE)
(86) Internationale Anmeldenummer: PCT/EP2012/055162
(87) Internationale Veröffentlichungsnummer: WO 2012/127021

(56) Entgegenhaltungen:
- EP-A2- 1 326 488
- US-A- 4 081 601
- US-A- 4 178 678
- US-A- 4 517 739

## Beschreibung

Die Erfindung betrifft ein Verfahren zur Herstellung eines elektrischen Kontaktaufnehmerplättchens und zur automatisierten Bestückung eines elektrischen oder elektronischen Moduls mit dem Kontaktaufnehmerplättchen gemäß Oberbegriff von Anspruch 1 sowie eine Bestückungsvorrichtung zur Herstellung eines elektrischen Kontaktaufnehmerplättchens und zur automatisierten Bestückung eines elektrischen oder elektronischen Moduls mit dem Kontaktaufnehmerplättchen gemäß Oberbegriff von Anspruch 10.

Für eine effiziente und automatisierte Herstellung von komplexen elektronischen Vorrichtungen werden die einzelnen elektronischen Bauelemente, welche gemeinsam die Vorrichtung bilden, üblicherweise zunächst zu einzelnen Modulen zusammengefasst. Diese Module sind beispielsweise einzelne Leiterplatten, welche einseitig oder auch beidseitig mit Bauelementen bestückt werden, bevor die Leiterplatten zur Fertigstellung der Vorrichtung miteinander elektrisch verbunden werden. Die elektrischen Verbindungen der einzelnen Leiterplatten bzw. Module sind oftmals als Steckverbindung oder als Federkontaktverbindung ausgeführt, da die Herstellung von Lötverbindungen zwischen den einzelnen Leiterplatten mit vergleichsweise großem Aufwand verbunden sind. Insbesondere Federkontaktverbindungen finden sich dabei in einer Vielzahl automatisiert hergestellter elektronischer Vorrichtungen, da sie gegenüber Steckverbindungen den Vorteil besitzen, während des Zusammenfügens der Module auftretende Ungenauigkeiten besser ausgleichen zu können.

In diesem Zusammenhang offenbart die DE 102 44 760 A1 eine Drucksensorbaugruppe, bestehend aus einem Drucksensorgehäuse, in welchem ein piezoelektrisches Messelement an der Oberfläche eines Messelementträgers angeordnet ist. Das Messelement weist eine Sensorelektronik auf, welche sich außerhalb des Drucksensorgehäuses in einem Reglergehäuse befindet. Zur Herstellung einer elektrischen Verbindung zwischen dem Reglergehäuse und dem Drucksensorgehäuse sind in einen Kontaktträger des Drucksensorgehäuses im Stanzverfahren hergestellte Dünnblechstreifen als Kontaktstellen eingebettet, welche von einem stabförmigen Federkontakt aus dem Reglergehäuse kontaktiert werden.

In der DE 10 2007 057 694 B4 wird ein Verfahren zur Leckageerkennung bei einem Gehäuse eines elektronischen Steuergeräts beschrieben. Das Verfahren umfasst eine Druckbeaufschlagung des Gehäuses und eine anschließende Auswertung der druckverursachten Deformation des Gehäuses. Die Deformation ist dabei ein Maß für die Dichtheit des Gehäuses und wird über einen oder mehrerer in das Gehäuse integrierte Federkontakte detektiert, die je nach Deformation bzw. Druckbeaufschlagung einen elektrischen Schaltkreis schließen oder auftrennen.

Aus der DE 10 2005 015 160 A1 ist ein kapazitiver Drucksensor für eine Kraftfahrzeugbremsanlage bekannt, der durch die Verbindung von metallischen Flächen eines Steuergeräts und einer Hydraulikeinheit gebildet wird. Die metallischen Flächen stellen einen Kondensator dar, dessen Kapazität bei einer druckverursachten Verformung geändert wird. Diese Änderung der Kapazität wiederum ist ein Maß für die Druckbeaufschlagung der metallischen Fläche. Die elektrischen Kontaktierungen der den Kondensator bildenden metallischen Flächen sowie einer Referenzkapazität werden dabei u.a. über Federkontakte hergestellt.

Da Federkontaktverbindungen jedoch bauartbedingt nicht die Robustheit einer Lötverbindung aufweisen können, ist es notwendig, bei der Herstellung derartiger elektrischer Verbindungen besondere Sorgfalt im Hinblick auf die unter allen Betriebsbedingungen stets zuverlässige elektrische Kontaktierung walten zu lassen. Dies geschieht gemäß dem Stand der Technik durch die Veredelung der Kontaktflächen mittels geeigneter Metalle, wie z.B. Gold, Silber oder Kupfer. Da die Herstellung sämtlicher Leiterbahnen und Kontaktstellen einer Leiterplatte aus den genannten Metallen jedoch einerseits zu teuer ist und andererseits die Verwendung unterschiedlicher Metalle für Leiterbahnen und Kontaktstellen mit unverhältnismäßig hohem Aufwand verbunden ist, werden die Kontaktstellen gemäß dem Stand der Technik während der Bestückung der Leiterplatte in Form von Kontaktaufnehmerplättchen auf die Leiterplatte aufgelötet, z.B. als SMD-Bauelemente. Diese Kontaktaufnehmerplättchen werden üblicherweise aus Blechtafeln oder Blechstreifen ausgestanzt und trotz der hohen Materialkosten beidseitig veredelt, da eine Ausrichtung der einzelnen Kontaktaufnehmerplättchen zu aufwändig ist und eine Falschbestückung der Leiterplatte zu einer reduzierten Prozessausbeute und somit höheren effektiven Herstellungskosten führt.

Ein Verfahren und eine Vorrichtung zur Befestigung einseitig veredelter Kontaktelemente an eine gedruckte Leiterplatte wird in der US 4 178 678 A beschrieben. Die Kontaktelemente sind vor der Befestigung auf der Leiterplatte durch zumindest einen Stützträger verbunden und weisen ein eine beschichtete Kontaktfläche schützendes Klebeband an einer Seite sowie eine Schicht thermisch härtbaren Klebstoffs auf einer gegenüberliegenden Seite auf. Die Kontaktelemente werden zunächst von dem Stützträger abgetrennt und, unterstützt durch das Klebeband, anschließend zu einer zweiten Station übertragen, an welcher die Befestigung an der entsprechend ausgerichteten Leiterplatte erfolgt.

Aus der US 4 517 739 A geht ein Verfahren zur Herstellung von Leiterplatten hervor, bei welchem mittels einer Stanz- und Presseinrichtung Kontaktelemente aus einem Streifen Kupferfolie auf der Leiterplatte angeordnet und mit dieser kontaktiert werden.

Daher ist es die Aufgabe der Erfindung, ein Verfahren vorzuschlagen, welches effiziente Anpassungen an unterschiedliche Abmessungen der Kontaktaufnehmerplättchen und eine kostengünstige Realisierung ermöglicht.

Diese Aufgabe wird erfindungsgemäß durch das Verfahren zur Herstellung eines elektrischen Kontaktaufnehmerplättchens und zur automatisierten Bestückung eines elektrischen oder elektronischen Moduls mit dem Kontaktaufnehmerplättchen gemäß Anspruch 1 gelöst.

Die Erfindung betrifft ein Verfahren zur Herstellung eines elektrischen Kontaktaufnehmerplättchens und zur automatisierten Bestückung eines elektrischen oder elektronischen Moduls mit dem Kontaktaufnehmerplättchen, bei welchem in einem Zuführschritt ein Endstück eines metallischen Folienstreifens zugeführt wird, bei welchem in einem Positionierungsschritt das Kontaktaufnehmerplättchen auf dem elektrischen oder elektronischen Modul positioniert wird und bei welchem in einem Befestigungsschritt das Kontaktaufnehmerplättchen auf dem elektrischen oder elektronischen Modul befestigt wird. Das Verfahren zeichnet sich dadurch aus, dass in einem Abtrennschritt, welcher auf den Zuführschritt folgt und dem Positionierungsschritt vorausgeht, das Kontaktaufnehmerplättchen mittels Abtrennen vom Folienstreifen hergestellt wird. Da die nach dem erfindungsgemäßen Verfahren hergestellten Kontaktaufnehmerplättchen direkt während des Bestückungsvorgangs hergestellt werden, ergibt sich zunächst der Vorteil, dass die Kontaktaufnehmerplättchen vor dem eigentlichen Bestückungsvorgang nicht in Magazine oder Gurte sortiert werden müssen, wodurch der Bestückungsaufwand verringert wird. Dies stellt eine wesentliche Vereinfachung an sich bekannter Bestückungsvorgänge dar. Da im Zuführschritt zudem ein Endstück eines Folienstreifens zugeführt wird, von welchem im Abtrennschritt die Kontaktaufnehmerplättchen abgetrennt werden, kann auch auf einfache Weise die Ausrichtung der Kontaktaufnehmerplättchen über die Ausrichtung des Folienstreifens kontrolliert werden, was eine nur einseitige Veredelung mit hochwertigerem Material der Kontaktaufnehmerplättchen ermöglicht. Eine aufwändige Ausrichtung der einzelnen Kontaktaufnehmerplättchen ist somit nicht mehr notwendig. Vielmehr ist es also ausreichend, den Folienstreifen bereits mit der gewünschten Ausrichtung zuzuführen. Da die Ausrichtung der Kontaktaufnehmerplättchen der Ausrichtung des Folienstreifens, von dem sie im Abtrennschritt abgetrennt werden, entspricht und vom Folienstreifen eine Vielzahl von Kontaktaufnehmerplättchen abgetrennt wird, ermöglicht die einmalige Ausrichtung des Folienstreifens die gleichzeitige Ausrichtung der Vielzahl von Kontaktaufnehmerplättchen. Dies stellt eine Vereinfachung und Effizienzsteigerung an sich bekannter Bestückungsvorgänge dar.

Die Kontaktaufnehmerplättchen werden jeweils vom Endstück des Folienstreifens abgetrennt, so dass der Folienstreifen durch jeden Abtrennschritt um die Länge eines Kontaktaufnehmerplättchens verkürzt wird.

Ebenfalls möglich im Sinne der Erfindung ist es, dass in jedem der genannten Schritte nicht nur ein einzelnes Kontaktaufnehmerplättchen hergestellt, bzw. positioniert und befestigt wird, sondern jeweils zwei oder mehr Kontaktaufnehmerplättchen gleichzeitig. Genauso ist es im Sinne der Erfindung möglich und bevorzugt, Streifenabschnitte, welche ebenfalls der Stromleitung dienen, abzutrennen und zu positioniere.

Bevorzugt ist es vorgesehen, dass der Folienstreifen mit einer vorgebbaren Schrittweite zugeführt wird. Durch die Möglichkeit, die Schrittweite im Zuführschritt vorzugeben, ergibt sich der Vorteil, dass je nach Bedarf ein oder mehrerer Kontaktaufnehmerplättchen gleichzeitig vom Folienstreifen abgetrennt bzw. aus dem Folienstreifen herausgetrennt werden können. Ebenso können unterschiedlich große Kontaktaufnehmerplättchen in abwechselnder Reihenfolge hergestellt werden, indem die Schrittweite jeweils an die Größe des als nächstes benötigten Kontaktaufnehmer-plättchens angepasst wird. Die Schrittweite kann dabei z.B. mittels Markierungen auf dem Folienstreifen vorgegeben sein, welche durch das erfindungsgemäße Verfahren erkannt werden.

Im Sinne der Erfindung bezeichnet der Begriff "schrittweite" nicht ausschließlich das Zuführen in einzelnen Schritten, welche jeweils durch ein Stillstehen des Folienstreifens voneinander separiert sind, sondern ebenfalls ein kontinuierliches Zuführen mit unterschiedlichen Geschwindigkeiten. In letzterem Fall wird eine große Schrittweite durch ein vorübergehend vergleichsweise schnelleres Zuführen realisiert, da ein schnelleres Zuführen zu einem vergleichsweise größeren zugeführten Teilstück des Folienstreifens im gleichen Zeitintervall führt. Umgekehrt kann eine kleine Schrittweite durch ein vorübergehend vergleichsweise langsameres Zuführen realisiert werden.

Unter dem Begriff "Kontaktaufnehmerplättchen" werden im Sinne der Erfindung nicht ausschließlich im Wesentlichen zweidimensionale Plättchen mit annäherungsweise identischen Erstreckungen in den beiden Ersteckungsdimensionen verstanden, wie z.B. Kreise, Ovale und Quadrate, sondern auch streifenartige Plättchen, deren Erstreckung in die eine Dimension die Erstreckung in die andere Dimension um ein Vielfaches übersteigt.

Außerdem ist es vorteilhaft, dass der Folienstreifen zu einer Rolle gewickelt oder auf eine Rolle aufgewickelt bevorratet wird, wobei die Rolle im Zuführschritt abgewickelt wird. Somit wird auf einfache Weise das Zuführen eines vergleichsweise langen Folienstreifens ermöglicht. Je länger der Folienstreifen ist, desto seltener muss das Verfahren unterbrochen werden, um einen neuen Folienstreifen bereitzustellen. Durch das Wickeln zu einer Rolle oder auf eine Rolle steht der Folienstreifen zudem vergleichsweise kompakt bevorratet zur Verfügung.

Weiterhin ist es vorteilhaft, dass der Folienstreifen von einer metallischen Folie abgetrennt wird, wobei zumindest eine erste Seite der Folie mit einer edelmetallischen Beschichtung beschichtet ist. Das Abtrennen von einer Folie ermöglicht auf einfache Weise die Herstellung des Folienstreifens. Indem die Folie zuvor einseitig edelmetallisch beschichtet wird, ergibt sich der weitere Vorteil, dass nicht jeder Folienstreifen einzeln beschichtet werden muss. Dies vereinfacht die Herstellung der beschichteten Folienstreifen maßgeblich und trägt bereits im Vorfeld zur Vereinfachung des erfindungsgemäßen Verfahrens gegenüber an sich bekannten, gattungsgemäßen Verfahren bei.

In einer weiteren bevorzugten Ausführungsform ist es vorgesehen, dass die Folie mit Formaussparungen versehen ist, welche eine Geometrie des Folienstreifens und/oder des Kontaktaufnehmerplättchens und/oder die Schrittweite des Zuführschritts prägen. Daraus ergibt sich der Vorteil, dass eine bestimmte Formgebung des Kontaktaufnehmerplättchens bereits vor dem Herstellungsverfahren und dem Bestückungsverfahren zumindest anteilig vorgegeben werden kann. Somit wird z.B. das Herstellen von nicht-rechteckigen Geometrien des Kontaktaufnehmerplättchens mittels eines einfachen Abtrennschritts möglich, ohne dass ein besonderes "Heraustrennen" notwendig ist. Zudem können die Formaussparungen auf einfache Weise als Markierungen genutzt werden, um die Schrittweite während des Zuführschritts vorzugeben.

Insbesondere ist es bevorzugt, dass die edelmetallische Beschichtung aus Gold oder Silber oder Nickel oder Kupfer oder aus einer mindestens eines dieser Metalle enthaltenden Legierung besteht. Diese Metalle bzw. Legierungen verfügen über vergleichsweise gute Eigenschaften als elektrische Leiter und ermöglichen somit eine elektrisch hochwertige Beschichtung.

Weiterhin ist es besonders bevorzugt, dass eine zweite Seite der Folie zusätzlich oder alternativ mit einer Beschichtung aus Lot beschichtet ist. Indem die zweite Seite der metallischen Folie mit Lot beschichtet ist, kann das Kontaktaufnehmerplättchen im Befestigungsschritt durch einfaches Erhitzen auf dem elektrischen oder elektronischen Modul angelötet und somit befestigt werden. Zudem muss nicht jedes Kontaktaufnehmerplättchen einzeln mit Lot beschichtet werden, was wiederum zur Vereinfachung des erfindungsgemäßen Verfahrens gegenüber den aus dem Stand der Technik bekannten Verfahren beiträgt. Außerdem ist es möglich, die Kontaktaufnehmerplättchen in einer auf das elektrische oder elektronischen Modul aufgedruckte Lötpaste zu positionieren und anschließend anzulöten.

Unter dem Begriff "Lot" ist im Sinne der Erfindung jedes zu einem Lötprozess geeignete Lotmittel, wie etwa Zinn oder ähnliche, an sich bekannte Legierungen, zu verstehen.

Es ist vorgesehen, dass eine Breite des Kontaktaufnehmerplättchens durch eine Breite des Folienstreifens festgelegt ist und eine Länge des Kontaktaufnehmerplättchens im Abtrennschritt festgelegt wird. Somit können die Abmessungen der Kontaktaufnehmerplättchen auf einfache Art und Weise festgelegt werden. Die Breite der Kontaktaufnehmerplättchen wird dabei im Vorfeld des Bestückungsvorgangs durch die Wahl der Breite des Folienstreifens festgelegt, während die Länge der Kontaktaufnehmerplättchen direkt während des Bestückungsvorgangs über die Schrittweite des Zuführschritts festgelegt und bedarfsgemäß vorgegeben werden kann.

Außerdem ist es vorteilhaft, dass das Kontaktaufnehmerplättchen im Wesentlichen scheibenförmig hergestellt wird. Es kann ein Folienstreifen zugeführt werden, der bereits mit Formaussparungen versehen ist, welche ein einfaches Abtrennen von vorgeformten, im Wesentlichen scheibenförmigen Kontaktaufnehmerplättchen erlauben.

In einer weiteren bevorzugten Ausführungsform ist es vorgesehen, dass das elektrische oder elektronische Modul eine Leiterplatte einer elektronischen Steuereinheit eines Fahrzeugbremsensystems ist. Da derartige Steuereinheiten in der Regel aus einer Mehrzahl von Leiterplatten bestehen, welche untereinander über elektrische Verbindungen verfügen müssen, findet das erfindungsgemäße Verfahren hier eine vorteilhafte Anwendung und trägt zur Vereinfachung und Effizienzsteigerung des Herstellungsprozesses der Steuereinheit bei.

Die vorliegende Erfindung betrifft weiterhin eine Bestückungsvorrichtung zur Herstellung eines elektrischen Kontaktaufnehmerplättchens und zur automatisierten Bestückung eines elektrischen oder elektronischen Moduls mit dem Kontaktaufnehmerplättchen, welche Zuführmittel und Positionierungsmittel und Befestigungsmittel umfasst. Die Zuführmittel führen ein Endstück eines metallischen Folienstreifens zu, die Positionierungsmittel positionieren das Kontaktaufnehmerplättchen auf dem elektrischen oder elektronischen Modul und die Befestigungsmittel befestigen das Kontaktaufnehmerplättchen auf dem elektrischen oder elektronischen Modul. Die Bestückungsvorrichtung zeichnet sich dadurch aus, dass sie zusätzlich Abtrennmittel umfasst, welche das Kontaktaufnehmerplättchen vom Folienstreifen abtrennen, wobei die Zuführmittel das Endstück des Folienstreifens den Abtrennmitteln zum Abtrennen zuführen, und dass die Bestückungsvorrichtung das erfindungsgemäße Verfahren ausführt. Da die erfindungsgemäße Bestückungsvorrichtung somit alle notwendigen Mittel zur Ausführung des erfindungsgemäßen Verfahrens umfasst und selbiges ausführt, ergeben sich die bereits beschriebenen Vorteile.

Bevorzugt ist es vorgesehen, dass die Bestückungsvorrichtung als SMD-Bestückungsvorrichtung ausgeführt ist und das elektrische oder elektronische Modul mit SMD-Elementen bestückt. SMD-Bestückungsvorrichtungen bieten aufgrund der geringen Größe der SMD-Bauelemente den Vorteil, dass eine dichte und kompakte Bestückung der Oberfläche eines elektrischen oder elektronischen Moduls ermöglicht wird. Die Kontaktaufnehmerplättchen werden in diesem Fall ebenfalls in der Größe der SMD-Bauelemente hergestellt und analog zu diesen auf dem elektrischen oder elektronischen Modul befestigt.

Weiterhin ist es bevorzugt, dass die Zuführmittel das Endstück des Folienstreifens mittels Abwickeln von einer Rolle zuführen und die Positionierungsmittel das Kontaktaufnehmerplättchen mittels Ansaugen aufnehmen und mittels einer koordinierten Bewegung auf dem elektrischen oder elektronischen Modul positionieren und mittels Beenden des Ansuagens ablegen und die Befestigungsmittel das Kontaktaufnehmerplättchen mittels Erhitzen auf das elektrische oder elektronische Modul löten oder mittels Leitkleben auf das elektrische oder elektronische Modul kleben. Die beschriebenen Mittel eignen sich, die erfindungsgemäße Bestückungsvorrichtung auf ebenso einfache wie effektive Weise zur Ausführung des erfindungsgemäßen Verfahrens zu befähigen.

Außerdem ist es vorteilhaft, dass die Abtrennmittel das Kontaktaufnehmerplättchen vom Folienstreifen mittels Schneiden oder Stanzen abtrennen. Sowohl ein Schneidvorgang als auch ein Stanzvorgang eignen sich zum Abtrennen, Heraustrennen oder Zertrennen des metallischen Folienstreifens. Da diese Vorgänge zudem einfach zu realisieren und umzusetzen sind, tragen sie zur Einfachheit, Robustheit und Effektivität der erfindungsgemäßen Bestückungsvorrichtung bei.

Außerdem ist es vorgesehen, dass die Bestückungsvorrichtung das elektrische oder elektronische Modul zusätzlich mit weiteren Elementen bestückt. Durch die gleichzeitige Bestückung des elektrischen oder elektronischen Moduls mit den erfindungsgemäßen Kontaktaufnehmerplättchen und weiteren Bauelementen bleibt der Gesamt-Bestückungsvorgang kompakt und kosteneffizient, da keine gesonderte Bestückungsvorrichtung benötigt wird, welche die Kontaktaufnehmerplättchen in einem gesonderten Verfahren herstellt und auf dem elektrischen oder elektronischen Modul befestigt.

Des Weiteren betrifft die vorliegende Erfindung betrifft ein Kontaktaufnehmerplättchen welches aus Gold oder Silber oder Nickel oder Kupfer oder aus einer mindestens eines dieser Metalle enthaltenden Legierung besteht und insbesondere mittels einer erfindungsgemäßen Bestückungsvorrichtung hergestellt wird. Das Kontaktaufnehmerplättchen zeichnet sich dadurch aus, dass es im Wesentlichen zweidimensional ist und eine Erstreckung in eine dritte Dimension nicht größer als 3 mm und insbesondere nicht größer als 1,5 mm ist. Durch die geringe Erstreckung des Kontaktaufnehmerplättchens in die dritte Dimension - also durch die geringe Höhe des Kontaktaufnehmerplättchen - ergibt sich der Vorteil, dass das Kontaktaufnehmerplättchen gegenüber gattungsgemäßen Kontaktaufnehmerplättchen vergleichsweise leicht ist und nur einen vergleichsweise geringen Materialbedarf aufweist, was wiederum die Herstellungskosten gering hält. Ein weiterer Vorteil ist, dass eine vergleichsweise große Anzahl an erfindungsgemäßen Kontaktaufnehmerplättchen platzsparend in Blister verpackt werden kann.

Die Erfindung betrifft weiterhin eine Verwendung des Kontaktaufnehmerplättchens als Kontaktstellenverbinder zwischen mindestens zwei elektrischen Kontaktstellen. Somit kann insbesondere ein streifenförmiges Kontaktaufnehmerplättchen dazu verwendet werden, zwei oder mehr Kontaktstellen auf ein und derselben Leiterplatte miteinander elektrisch zu verbinden. Hierbei kann z.B. auch eine auf der Leiterplatte befindliche Leiterbahn überbrückt werden. Ebenso ist es möglich und bevorzugt, zwei oder mehr Kontaktstellen auf unterschiedlichen Leiterplatten miteinander zu verbinden.

Weitere bevorzugte Ausführungsformen ergeben sich aus den Unteransprüchen und der nachfolgenden Beschreibung eines Ausführungsbeispiels anhand von Figuren.

Es zeigen
- Fig. 1: ein Flussdiagramm, welches die einzelnen Ablaufschritte einer möglichen Ausführungsform des erfindungsgemäßen Verfahrens darstellt,
- Fig. 2: schematisch einen möglichen Aufbau der erfindungsgemäßen Vorrichtung und
- Fig. 3: eine metallische Folie, von welcher ein metallischer Folienstreifen abgetrennt wird sowie Folienstreifen mit unterschiedlichen Formaussparungen.

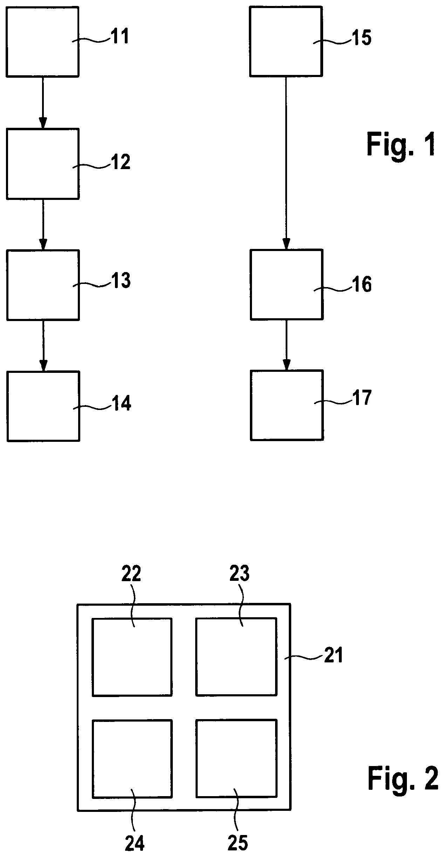

Fig. 1 zeigt einen beispielhaften und schematischen Ablauf des erfindungsgemäßen Verfahrens in Form eines Flussdiagramms. In Schritt 11 wird zunächst ein Endstück eines metallischen Folienstreifens innerhalb der Bestückungsvorrichtung automatisiert den Abtrennmitteln zugeführt. Bei dem Folienstreifen handelt es sich um Blechfolie, deren Oberseite mit einer Goldbeschichtung bedampft wurde, während die Unterseite mit einer Zinnlegierung galvanisch beschichtet wurde. Im Analogen Verfahren zu Schritt 11 wird in Verfahrensschritt 15 ein SMD-Widerstand aus einem dafür vorgesehenen Magazinstreifen, welcher beispielsgemäß als sog. Blister ausgeführt ist, entnommen. Auch dieser Schritt läuft automatisiert und mittels derselben Bestückungsvorrichtung ab. In Verfahrensschritt 12 wird das Endstück des Folienstreifens in einem Schneidvorgang abgetrennt. Das solcherart abgetrennte Folienstück stellt ein Kontaktaufnehmerplättchen dar. Im folgenden Schritt 13 wird das Kontaktaufnehmerplättchen mittels eines Unterdrucksaugers angesaugt und auf der zu bestückenden Leiterplatte positioniert. Das Ablegen auf der Leiterplatte erfolgt, indem die Unterdruckerzeugung automatisiert abgestellt wird und das Kontaktaufnehmerplättchen an der dafür vorgesehenen, mit Lötpaste versehenen Stelle abgelegt wird. Einen analogen Positionierungsschritt stellt Verfahrensschritt 16 dar, in welchem der SMD-Widerstand ebenfalls an der hierfür vorgesehenen, mit Lötpaste versehenen Stelle auf der Leiterplatte positioniert und abgelegt wird. In Schritt 14 werden mittels eines sog. Reflowlötprozesses alle Lötstellen gleichzeitig erhitzt, zum Aufschmelzen gebracht und damit letztendlich verlötet. Dies bewirkt im Falle des Kontaktaufnehmerplättchens ein Aufschmelzen der Lötpaste unter dem Kontaktaufnehmerplättchen, mit welcher die Unterseite des Kontaktaufnehmerplättchens in Berührung steht. Da die Erhitzung nur von kurzer Dauer ist, erkalten sowohl die Zinnlegierung als auch die Lötpaste schnell und nehmen einen festen Aggregatszustand ein. Somit ist das Kontaktaufnehmerplättchen auf die Leiterplatte gelötet. In Schritt 17 erfolgt die Befestigung des positionierten SMD-Widerstands mittels sog. Leitklebens.

Ein möglicher Aufbau von erfindungsgemäßer Bestückungsvorrichtung 21 ist schematisch in Fig. 2 zu sehen. Bestückungsvorrichtung 21 umfasst Zuführmittel 22, Abtrennmittel 23, Positionierungsmittel 24 und Befestigungsmittel 25. Zuführmittel 22 wickeln eine Rolle, welche einen aufgewickelten metallischen Folienstreifen enthält, schrittweise ab und führen ein Endstück des Folienstreifens Abtrennmitteln 23 zu. Abtrennmittel 23 sind in Form eines Stanzers ausgeführt, welcher das Endstück des Folienstreifens mittels Stanzen abtrennt. Das abgetrennte Endstück stellt das Kontaktaufnehmerplättchen dar. Positionierungsmittel 24 bestehen aus einem beweglichen Positionierungsarm, welcher mittels Unterdruckerzeugung das Kontaktaufnehmerplättchen aufgreift und an der dafür vorgesehenen Stelle auf einer zu bestückenden Leiterplatte positioniert und ablegt. Befestigungsmittel 25 sind als beweglicher Arm mit Lötspitze ausgebildet, wobei die Lötspitze die Leiterplatte an der Stelle des darauf positionierten Kontaktaufnehmerplättchens lokal erhitzt, um einen Lötprozess zu bewirken und das Kontaktaufnehmerplättchen auf diese Weise auf der Leiterplatte zu befestigen.

Gemäß einem weiteren Ausführungsbeispiel in Fig. 2 sind Befestigungsmittel 25 als Heizplatte ausgeführt, welche alle Lötstellen gleichzeitig erhitzt und aufschmelzen lässt. Diese Ausführungsform ermöglicht ein schnelleres Befestigen bzw. Anlöten der Kontaktaufnehmerplättchen mit vergleichsweise geringem Aufwand.

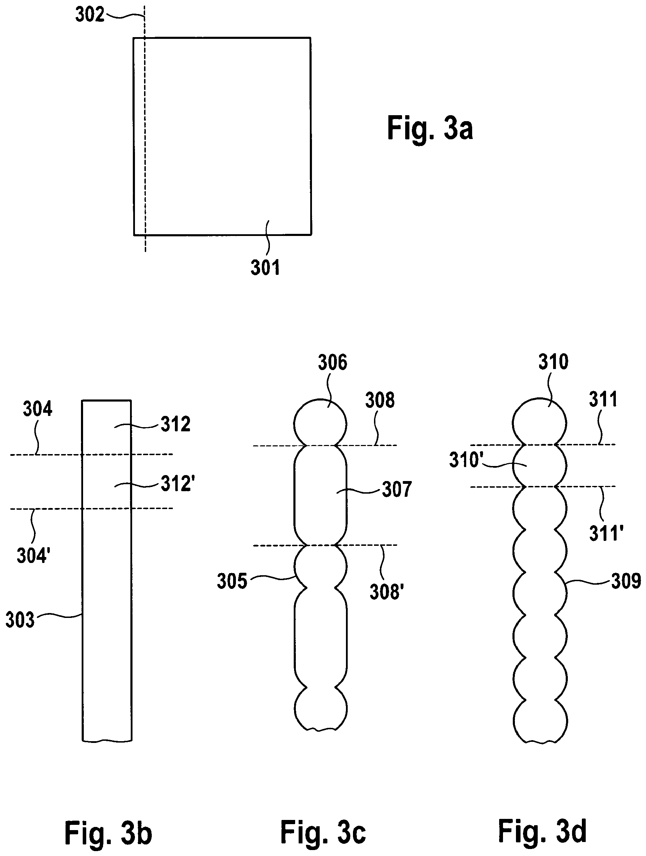

In Fig. 3a ist beispielhaft metallische Folie 301 dargestellt. Metallische Folie 301 besteht aus dünn gewalztem Kupferblech und ist auf der Oberseite mit einer Silber-Legierung zur Verbesserung der elektrischen Leitfähigkeit beschichtet. Die Unterseite von metallischer Folie 301 ist mit einer Zinnlegierung beschichtet, welche sich für eine gute Lötanbindung eignet.

Von metallischer Folie 301 wird nun entlang gestrichelter Linie 302 Folienstreifen 303 (Fig. 3b) abgetrennt. Das Abtrennen erfolgt mittels eines automatisierten Blechschneidevorgangs.

Gemäß einem weiteren Ausführungsbeispiel in Fig. 3 wird nicht metallische Folie 301 mit einer Zinnlegierung beschichtet, sondern Folienstreifen 303 wird nach dem Abtrennen von metallischer Folie 301 galvanisch beschichtet.

Folienstreifen 303 wird anschließend auf eine Rolle aufgewickelt und während des Zuführschritts des erfindungsgemäßen Verfahrens schrittweise wieder abgewickelt. Von Folienstreifen 33 werden während des Abtrennschritts des erfindungsgemäßen Verfahrens, welcher als Stanzschritt ausgeführt wird, entlang Linien 304 und 304' Kontaktaufnehmerplättchen 312 und 312' mittels Stanzen abgetrennt. Aufgrund der Geometrie von Folienstreifen 303 und des einfachen Abtrennschritts sind hergestellte Kontaktaufnehmerplättchen 312 und 312' rechteckig. Die Breite von Kontaktaufnehmerplättchen 312 und 312' wird durch die Breite von Folienstreifen 303 vorgegeben. Die Länge von Kontaktaufnehmerplättchen 312 und 312' wird hingegen durch die eingestellte Schrittweite des Zuführschritts festgelegt und kann bedarfsgemäß vorgegeben werden.

Fig. 3c stellt eine weitere beispielhafte Ausformungsmöglichkeit von Folienstreifen 305 dar. Folienstreifen 305 ist mit Materialaussparungen versehen, welche die unterschiedlichen Geometrien von Kontaktaufnehmerplättchen 306 und 307 prägen. Die Materialaussparungen wurden mittels eines Stanzverfahrens bereits in Folie 301 eingebracht, bevor Folienstreifen 305 von dieser abgetrennt wurde. Die Materialaussparungen dienen außerdem während des Zuführschritts dazu, eine Schrittweite vorzugeben. Mittels einer geeigneten Vorrichtung werden die Aussparungen erkannt und verhindern ein weiteres Zuführen, solange nicht ein Abtrennschritt erfolgt ist. Das Abtrennen von Kontaktaufnehmerplättchen 306 bzw. 307 von Folienstreifen 305 erfolgt entlang von gestrichelten Linien 308 und 308'. Wie zu sehen ist, ergeben sich somit abwechselnd zwei unterschiedliche Geometrien für die hergestellten Kontaktaufnehmerplättchen, nämlich einmal eine im Wesentlichen scheibenförmige Geometrie und einmal eine in etwa ovale Geometrie. Die Reihenfolge der Geometrien ist dabei an die Erfordernisse zur Bestückung der zu bestückenden Leiterplatte angepasst.

In Fig. 3d ist eine weitere Ausformungsmöglichkeit von Folienstreifen 309 zu sehen. Beispielsgemäß sind herzustellende Kontaktaufnehmerplättchen 310 und 310' im Wesentlichen scheibenförmig. Andere Geometrien von Kontaktaufnehmerplättchen 310 und 310' sind in diesem Falle nicht vorgesehen. Die Materialaussparungen an Folienstreifen 309 dienen zum Vorgeben einer Schrittweite während des Zuführschritts. Das Abtrennen findet entlang von gestrichelten Linien 311 bzw. 311' statt.

## Patentansprüche

1. Verfahren zur Herstellung eines elektrischen Kontaktaufnehmerplättchens (306, 307, 310, 310', 312, 312') und zur automatisierten Bestückung eines elektrischen oder elektronischen Moduls mit dem Kontaktaufnehmerplättchen (306, 307, 310, 310', 312, 312'),
- bei welchem in einem Zuführschritt (11) ein Endstück eines metallischen Folienstreifens (303, 305, 309) zugeführt wird,
- bei welchem in einem Positionierungsschritt (13) das Kontaktaufnehmerplättchen (306, 307, 310, 310', 312, 312') auf dem elektrischen oder elektronischen Modul positioniert wird und
- bei welchem in einem Befestigungsschritt (14) das Kontaktaufnehmerplättchen (306, 307, 310, 310', 312, 312') auf dem elektrischen oder elektronischen Modul befestigt wird, wobei
in einem Abtrennschritt (12), welcher auf den Zuführschritt (11) folgt und dem Positionierungsschritt (13) vorausgeht, das Kontaktaufnehmerplättchen (306, 307, 310, 310', 312, 312') mittels Abtrennen vom Endstück des Folienstreifens (303, 305, 309) hergestellt wird, wobei eine Breite des Kontaktaufnehmerplättchens (306, 307, 310, 310', 312, 312') durch eine Breite des Folienstreifens (303, 305, 309) festgelegt ist und eine Länge des Kontaktaufnehmerplättchens (306, 307, 310, 310', 312, 312') im Abtrennschritt (12) festgelegt wird.

2. Verfahren nach Anspruch 1,
**dadurch gekennzeichnet,**
**dass** der Folienstreifen (303, 305, 309) mit einer vorgebbaren Schrittweite zugeführt wird.

3. Verfahren nach mindestens einem der Ansprüche 1 und 2,
**dadurch gekennzeichnet,**
**dass** der Folienstreifen (303, 305, 309) zu einer Rolle gewickelt oder auf eine Rolle aufgewickelt bevorratet wird, wobei die Rolle im Zuführschritt (11) abgewickelt wird.

4. Verfahren nach mindestens einem der Ansprüche 1 bis 3,
**dadurch gekennzeichnet,**
**dass** der Folienstreifen (303, 305, 309) von einer metallischen Folie (301) abgetrennt wird, wobei zumindest eine erste Seite der Folie (301) mit einer edelmetallischen Beschichtung beschichtet ist.

5. Verfahren nach mindestens einem der Ansprüche 1 bis 4,
**dadurch gekennzeichnet,**
**dass** die Folie (301) mit Formaussparungen versehen ist, welche eine Geometrie des Folienstreifens (303, 305, 309) und/oder des Kontaktaufnehmerplättchens (306, 307, 310, 310', 312, 312') und/oder die Schrittweite des Zuführschritts (11) prägen.

6. Verfahren nach Anspruch 3,
**dadurch gekennzeichnet,**
**dass** die edelmetallische Beschichtung aus Gold oder Silber oder Nickel oder Kupfer oder aus einer mindestens eines dieser Metalle enthaltenden Legierung besteht.

7. Verfahren nach Anspruch 3,
**dadurch gekennzeichnet,**
**dass** eine zweite Seite der Folie (301) zusätzlich oder alternativ mit einer Beschichtung aus Lot beschichtet ist.

8. Verfahren nach mindestens einem der Ansprüche 1 bis 7,
**dadurch gekennzeichnet,**
**dass** das Kontaktaufnehmerplättchen (306, 307, 310, 310', 312, 312') im Wesentlichen scheibenförmig hergestellt wird.

9. Verfahren nach mindestens einem der Ansprüche 1 bis 8,
**dadurch gekennzeichnet,**
**dass** das elektrische oder elektronische Modul eine Leiterplatte einer elektronischen Steuereinheit eines Fahrzeugbremsensystems ist.

10. Bestückungsvorrichtung (21) zur Herstellung eines elektrischen Kontaktaufnehmerplättchens (306, 307, 310, 310', 312, 312') und zur automatisierten Bestückung eines elektrischen oder elektronischen Moduls mit dem Kontaktaufnehmerplättchen (306, 307, 310, 310', 312, 312'), umfassend Zuführmittel (22) und Positionierungsmittel (24) und Befestigungsmittel (25),
wobei die Positionierungsmittel (24) das Kontaktaufnehmerplättchen (306, 307, 310, 310', 312, 312') auf dem elektrischen oder elektronischen Modul positionieren und
wobei die Befestigungsmittel (25) das Kontaktaufnehmerplättchen (306, 307, 310, 310', 312, 312') auf dem elektrischen oder elektronischen Modul befestigen, **dadurch gekennzeichnet, dass** die Zuführmittel (22) ein Endstück eines metallischen Folienstreifens (303, 305, 309) zuführen und dass die Bestückungsvorrichtung (21) zusätzlich Abtrennmittel (23) umfasst, welche das Kontaktaufnehmerplättchen (306, 307, 310, 310', 312, 312') vom Endstück des Folienstreifens (303, 305, 309) abtrennen, wobei die Zuführmittel (22) das Endstück des Folienstreifens (303, 305, 309) den Abtrennmitteln zum Abtrennen zuführen, und dass die Bestückungsvorrichtung (21) ein Verfahren nach mindestens einem der Ansprüche 1 bis 9 ausführt.

11. Bestückungsvorrichtung (21) nach Anspruch 10,
**dadurch gekennzeichnet,**
**dass** die Bestückungsvorrichtung (21) als SMD-Bestückungsvorrichtung (21) ausgeführt ist und das elektrische oder elektronische Modul mit SMD-Elementen bestückt.

12. Bestückungsvorrichtung (21) nach mindestens einem der Ansprüche 10 und 11,
**dadurch gekennzeichnet,**
**dass** die Zuführmittel (22) das Endstück des Folienstreifens (303, 305, 309) mittels Abwickeln von einer Rolle zuführen und
die Positionierungsmittel (24) das Kontaktaufnehmerplättchen (306, 307, 310, 310', 312, 312') mittels Ansaugen aufnehmen und mittels einer koordinierten Bewegung auf dem elektrischen oder elektronischen Modul positionieren und mittels Beenden des Ansaugens ablegen und die Befestigungsmittel (25) das Kontaktaufnehmerplättchen (306, 307, 310, 310', 312, 312') mittels Erhitzen auf das elektrische oder elektronische Modul löten oder mittels Leitkleben auf das elektrische oder elektronische Modul kleben.

13. Bestückungsvorrichtung (21) nach mindestens einem der Ansprüche 10 bis 12,
**dadurch gekennzeichnet,**
**dass** die Abtrennmittel (23) das Kontaktaufnehmerplättchen (306, 307, 310, 310', 312, 312') vom Folienstreifen (303, 305, 309) mittels Schneiden oder Stanzen abtrennen.

14. Bestückungsvorrichtung (21) nach mindestens einem der Ansprüche 10 bis 13,
**dadurch gekennzeichnet,**
**dass** die Bestückungsvorrichtung (21) das elektrische oder elektronische Modul zusätzlich mit weiteren Elementen bestückt.

## Claims

1. Method for producing an electric contact sensor plate (306, 307, 310, 310', 312, 312') and for populating an electric or electronic module with the contact sensor plate (306, 307, 310, 310', 312, 312') in an automated manner,
- in which an end piece of a metal foil strip (303, 305, 309) is fed in a feeding step (11),
- in which the contact sensor plate (306, 307, 310, 310', 312, 312') is positioned on the electric or electronic module in a positioning step (13), and
- in which the contact sensor plate (306, 307, 310, 310', 312, 312') is fastened on the electric or electronic module in a fastening step (14), wherein
the contact sensor plate (306, 307, 310, 310', 312, 312') is produced by being severed from the end piece of the foil strip (303, 305, 309) in a severing step (12) that follows the feeding step (11) and precedes the positioning step (13), wherein a width of the contact sensor plate (306, 307, 310, 310', 312, 312') is defined by a width of the foil strip (303, 305, 309), and a length of the contact sensor plate (306, 307, 310, 310', 312, 312') is defined in the severing step (12).

2. Method according to Claim 1,
**characterized in that**
the foil strip (303, 305, 309) is fed with a predefinable step width.

3. Method according to at least one of Claims 1 and 2,
**characterized in that**
the foil strip (303, 305, 309) is stored wound into a roll or wound onto a roll, wherein the roll is unwound in the feeding step (11).

4. Method according to at least one of Claims 1 to 3,
**characterized in that**
the foil strip (303, 305, 309) is severed from a metal foil (301), wherein at least a first side of the foil (301) is coated with a noble-metal coating.

5. Method according to at least one of Claims 1 to 4,
**characterized in that**
the foil (301) is provided with shaped recesses, which form a geometry of the foil strip (303, 305, 309) and/or of the contact sensor plate (306, 307, 310, 310', 312, 312') and/or of the step width of the feeding step (11).

6. Method according to Claim 3,
**characterized in that**
the noble-metal coating consists of gold or silver or nickel or copper or of an alloy containing at least one of these metals.

7. Method according to Claim 3,
**characterized in that**
a second side of the foil (301) is coated additionally or alternatively with a coating formed of solder.

8. Method according to at least one of Claims 1 to 7,
**characterized in that**
the contact sensor plate (306, 307, 310, 310', 312, 312') is produced substantially in a disk-shaped manner.

9. Method according to at least one of Claims 1 to 8,
**characterized in that**
the electric or electronic module is a printed circuit board of an electronic control unit of a vehicle braking system.

10. Populating device (21) for producing an electric contact sensor plate (306, 307, 310, 310', 312, 312') and for populating an electric or electronic module with the contact sensor plate (306, 307, 310, 310', 312, 312') in an automated manner, comprising feeding means (22) and positioning means (24) and fastening means (25),
wherein the positioning means (24) position the contact sensor plate (306, 307, 310, 310', 312, 312') on the electric or electronic module, and
wherein the fastening means (25) fasten the contact sensor plate (306, 307, 310, 310', 312, 312') on the electric or electronic module,
**characterized in that**
the feeding means (22) feed an end piece of a metal foil strip (303, 305, 309), and **in that**
the populating device (21) additionally comprises severing means (23), which sever the contact sensor plate (306, 307, 310, 310', 312, 312') from the end piece of the foil strip (303, 305, 309), wherein the feeding means (22) feed the end piece of the foil strip (303, 305, 309) to the severing means for severing, and **in that** the populating device (21) carries out a method according to at least one of Claims 1 to 9.

11. Populating device (21) according to Claim 10,
**characterized in that**
the populating device (21) is formed as an SMD populating device (21) and populates the electric or electronic module with SMD elements.

12. Populating device (21) according to at least one of Claims 10 and 11,
**characterized in that**
the feeding means (22) feed the end piece of the foil strip (303, 305, 309) by means of unwinding from a roll, and
the positioning means (24) pick up the contact sensor plate (306, 307, 310, 310', 312, 312') by means of suction and position it on the electric or electronic module by means of a coordinated movement and deposit it by terminating the suction, and the fastening means (25) solder the contact sensor plate (306, 307, 310, 310', 312, 312') onto the electric or electronic module by means of heating or adhesively bond the contact sensor plate onto the electric or electronic module by means of conductive adhesive bonding.

13. Populating device (21) according to at least one of Claims 10 to 12,
**characterized in that**
the severing means (23) sever the contact sensor plate (306, 307, 310, 310', 312, 312') from the foil strip (303, 305, 309) by means of cutting or punching.

14. Populating device (21) according to at least one of Claims 10 to 13,
**characterized in that**
the populating device (21) additionally populates the electric or electronic module with further elements.

## Revendications

1. Procédé pour fabriquer une plaquette réceptrice de contact électrique (306, 307, 310, 310', 312, 312') et pour équiper automatiquement un module électrique ou électronique avec la plaquette réceptrice de contact (306, 307, 310, 310', 312, 312'),
- selon lequel, lors d'une étape d'amenée (11), une pièce d'extrémité d'une bande de feuille métallique (303, 305, 309) est amenée,
- selon lequel, lors d'une étape de positionnement (13), la plaquette réceptrice de contact (306, 307, 310, 310', 312, 312') est positionnée sur le module électrique ou électronique, et
- selon lequel, lors d'une étape de fixation (14), la plaquette réceptrice de contact (306, 307, 310, 310', 312, 312') est fixée sur le module électrique ou électronique, dans lequel,
lors d'une étape de séparation (12) qui suit l'étape d'amenée (11) et précède l'étape de positionnement (13), la plaquette réceptrice de contact (306, 307, 310, 310', 312, 312') est fabriquée par séparation de la bande de feuille (303, 305, 309),
une largeur de la plaquette réceptrice de contact (306, 307, 310, 310', 312, 312') étant définie par une largeur de la bande de feuille (303, 305, 309) et une longueur de la plaquette réceptrice de contact (306, 307, 310, 310', 312, 312') étant définie lors de l'étape de séparation (12).

2. Procédé selon la revendication 1, **caractérisé en ce que** la bande de feuille (303, 305, 309) est amenée avec une largeur de pas pouvant être prédéfinie.

3. Procédé selon au moins l'une des revendications 1 et 2, **caractérisé en ce que** la bande de feuille (303, 305, 309) est enroulée en un rouleau ou enroulée sur un rouleau, le rouleau étant déroulé lors de l'étape d'amenée (11).

4. Procédé selon au moins l'une des revendications 1 à 3, **caractérisé en ce que** la bande de feuille (303, 305, 309) est séparée d'une feuille métallique (301), au moins une première face de la feuille (301) étant revêtue d'un revêtement de métal noble.

5. Procédé selon au moins l'une des revendications 1 à 4, **caractérisé en ce que** la feuille (301) est munie d'évidements de moulage qui forment une géométrie de la bande de feuille (303, 305, 309) et/ou de la plaquette réceptrice de contact (306, 307, 310, 310', 312, 312') et la largeur de pas de l'étape d'amenée (11).

6. Procédé selon la revendication 3, **caractérisé en ce que** le revêtement de métal précieux est constitué d'or ou d'argent ou de nickel ou de cuivre ou d'un alliage contenant au moins l'un de ces métaux.

7. Procédé selon la revendication 3, **caractérisé en ce qu'**une deuxième face de la feuille (301) est en outre ou en variante revêtue d'un revêtement de soudure.

8. Procédé selon au moins l'une des revendications 1 à 7, **caractérisé en ce que** la plaquette réceptrice de contact (306, 307, 310, 310', 312, 312') est réalisée sensiblement sous forme de disque.

9. Procédé selon au moins l'une des revendications 1 à 8, **caractérisé en ce que** le module électrique ou électronique est une carte de circuit imprimé d'une unité de commande électronique d'un système de freinage pour véhicule.

10. Dispositif d'implantation (21) pour fabriquer une plaquette réceptrice de contact électrique (306, 307, 310, 310', 312, 312') et pour équiper automatiquement un module électrique ou électronique avec la plaquette réceptrice de contact (306, 307, 310, 312, 312'), comprenant des moyens d'amenée (22), des moyens de positionnement (24), des moyens de fixation (25),
dans lequel les moyens de positionnement (24) positionnent la plaquette réceptrice de contact (306, 307, 310, 310', 312, 312') sur le module électrique ou électronique et
dans lequel les moyens de fixation (25) fixent la plaquette réceptrice de contact (306, 307, 310, 310', 312, 312') sur le module électrique ou électronique, **caractérisé en ce que** les moyens d'amenée (22) amènent une pièce d'extrémité d'une bande de feuille métallique (303, 305, 309) et **en ce que** le dispositif d'implantation (21) comprend en outre des moyens de séparation (23) qui séparent la plaquette réceptrice de contact (306, 307, 310, 310', 312, 312') de la pièce d'extrémité de la bande de feuille (303, 305, 309), dans lequel les moyens d'amenée (22) amènent la pièce d'extrémité de la bande de feuille (303, 305, 309) vers les moyens de séparation à des fins de séparation, et **en ce que** le dispositif d'implantation (21) met en oeuvre un procédé selon au moins l'une des revendications 1 à 9.

11. Dispositif d'implantation (21) selon la revendication 10, **caractérisé en ce que** le dispositif d'implantation (21) est réalisé sous la forme d'un dispositif d'implantation SMD (21) et **en ce que** le module électrique ou électronique est équipé d'éléments SMD.

12. Dispositif d'implantation (21) selon au moins l'une des revendications 10 et 11, **caractérisé en ce que** les moyens d'amenée (22) amènent la pièce d'extrémité de la bande de feuille (303, 305, 309) par déroulement d'un rouleau et
les moyens de positionnement (24) reçoivent la plaquette réceptrice de contact (306, 307, 310, 310', 312, 312') par aspiration et la positionnent au moyen d'un mouvement coordonné sur le module électrique ou électronique et la déposent par interruption de l'aspiration et les moyens de fixation (25) soudent la plaquette réceptrice de contact (306, 307, 310, 310', 312, 312') sur le module électrique ou électronique par chauffage ou la collent au module électrique ou électronique au moyen d'un adhésif conducteur.

13. Dispositif d'implantation (21) selon au moins l'une des revendications 10 à 12, **caractérisé en ce que** les moyens de séparation (23) séparent la plaquette réceptrice de contact (306, 307, 310, 310', 312, 312') de la bande de feuille (303, 305, 309) par découpage ou estampage.

14. Dispositif d'implantation (21) selon au moins l'une des revendications 10 à 13, **caractérisé en ce que** le dispositif d'implantation (21) équipe en outre le module électrique ou électronique avec d'autres éléments.
